# EUROPEAN PATENT SPECIFICATION

(11) **EP 2 690 656 B1**
(45) Date of publication and mention of the grant of the patent: **09.01.2019**
(21) Application number: 12864852.4
(22) Date of filing: 02.11.2012
(51) Int. Cl.: H01L 23/36, H05K 7/20

(54) **POWER DEVICE INSULATING HEAT RADIATION STRUCTURE AND CIRCUIT BOARD**
WÄRMESTRAHLUNGSSTRUKTUR ZUR ISOLIERUNG EINER STROMVERSORGUNGSVORRICHTUNG UND LEITERPLATTE
STRUCTURE D'ISOLATION À RAYONNEMENT THERMIQUE POUR DISPOSITIF D'ALIMENTATION ET CIRCUIT IMPRIMÉ

(30) Priority: 11.01.2012 CN 201210007075
(43) Date of publication of application: 29.01.2014
(73) Proprietor: Huawei Technologies Co., Ltd., Longgang District Shenzhen, Guangdong 518129 (CN)
(72) Inventor: XU, Yan, Shenzhen Guangdong 518129 P.R. (CN); CHEN, Baoguo, Shenzhen Guangdong 518129 P.R. (CN); ZHAO, Guoyuan, Shenzhen Guangdong 518129 P.R. (CN)
(74) Representative: Pfenning, Meinig & Partner mbB
(86) International application number: PCT/CN2012/083946
(87) International publication number: WO 2013/104206

(56) References cited:
- CN-A- 1 419 803
- CN-A- 101 476 683
- CN-A- 101 867 286
- CN-A- 102 569 223
- CN-Y- 201 248 220
- DE-U1- 8 908 678
- US-A1- 2010 226 095
- US-A1- 2010 271 785
- US-A1- 2011 261 535
- US-B2- 6 849 943
- US-B2- 7 151 669

## Description

### FIELD OF THE INVENTION

The present invention relates to the field of power supply products, and in particular, to an insulation and heat radiation structure of a power device and a circuit board.

### BACKGROUND OF THE INVENTION

Power devices such as a power switch tube and a rectifier are widely applied in a power supply product, where installation of the power device should meet requirements of both heat radiation and insulation. A space occupied by the insulation and heat radiation structure of the power device is a key factor affecting a power density of a power supply apparatus.

In the power supply product, a common insulation and heat radiation structure of the power device is formed by a screw, an insulating particle, a power device, and a heat radiator, where the power device is fixed on a contact heat radiation surface of the heat radiator through the screw and the insulating particle. Another common insulation and heat radiation structure of the power device is formed by an elastic batten, a power device, and a heat radiator, where the power device is clamped on a contact heat radiation surface of the heat radiator through the elastic batten.

In the insulation and heat radiation structures of the power device, by fixing the power device on the contact heat radiation surface of the heat radiator through the screw and the insulating particle or by clamping the power device on the contact heat radiation surface of the heat radiator through the elastic batten, the space occupied by the insulation and heat radiation structure of the power device is great, thereby decreasing the power density of the power supply apparatus.

US 2005/0261535 A1 discloses a power module comprising a power module board including an insulating layer and a conductive circuit formed on the insulating layer, a power device provided on the power module board and electrically connected to the conductive circuit, and a thermal conductive sheet for dissipating the heat generated from the power module board and/or the power device. The thermal conductive sheet contains a plate-like boron nitride particle and the thermal conductivity in a direction perpendicular to the thickness direction of the thermal conductive sheet is 4 W/mK or more.

US 2005/0013120 A1 relates to a configurable heat sink with matrix clipping system. According to this document, a heat sink apparatus for use with electronic components comprises a base frame, a clipping system and a plurality of supporting members. The base frame and the clipping system and the supporting members are of unitary construction. The base frame is configured to have "i" repeatable channels with fins extended from or attached to its outside surfaces. The clipping system comprises a matrix [i, j] set of ixj spring clips. Each spring clip is configured to have partially constrained with the base frame, and to flex about an axis resiliently to effect an engaged relation to substantially fixedly maintain the electronic component in abutting relation with the inside walls of the channel. The supporting members are configured to have fixed connection with the base frame and be solderable. The heat sink apparatus's capacity of holding electronic components is scalable to accommodate upgrades and design changes of electronic products.

US 2010/0271785 A1 is directed to a heat-dissipating and fixing mechanism of an electronic component and a process for assembling the same. The heat-dissipating and fixing mechanism of an electronic component includes a heat-dissipating element, a circuit board and a thermally-conductive adhesive interface. The circuit board has multiple insertion holes. The pins of the electronic component are inserted into corresponding insertion holes of the circuit board. The thermally-conductive adhesive interface has a first surface bonded with the heat-dissipating element and a second surface bonded with the electronic component. As a consequence, the electronic component is fixed on the heat-dissipating element through the thermally-conductive adhesive interface, and the heat generated by the electronic component is transmitted to the heat-dissipating element through the thermally-conductive adhesive interface.

### SUMMARY OF THE INVENTION

Embodiments of the present invention provide an insulation and heat radiation structure of a power device, a circuit board, and a power supply apparatus, where the insulation and heat radiation structure occupies a small space, thereby significantly improving a power density of the power supply apparatus.

An insulation and heat radiation structure of a power device includes:
a power device, an insulation ceramic piece, and a heat radiator, where
the power device is of a sheet structure, wherein a power device pin is disposed on the power device, and the power device pin is used for being electrically connected to the circuit board, the insulation ceramic piece is an alumina ceramic piece, a heat radiator pin is disposed on the heat radiator, and the heat radiator pin is used for being mechanically connected to a circuit board; and
the power device, the insulation ceramic piece, and the heat radiator are sequentially fixed in a transverse direction with regard to the plane of the sheet structure, a heating surface of the power device is adhesively fixed to one surface of the insulation ceramic piece through a first insulating thermal conductive adhesive, and the other surface of the insulation ceramic piece is adhesively fixed to a contact heat radiation surface of the heat radiator through a second insulating thermal conductive adhesive,
wherein the second insulating thermal conductive adhesive is an organic insulating thermal conductive adhesive with a thermal conductivity coefficient greater than 0.3 w/mk and with a modulus of elasticity of less than 5 GPa after being cured at a temperature of 25°C.

A circuit board includes an insulation and heat radiation structure of a power device formed by a power device, an insulation ceramic piece, and a heat radiator, where the power device is of a sheet structure, wherein a power device pin is disposed on the power device, and the power device pin is used for being electrically connected to the circuit board, the insulation ceramic piece is an alumina ceramic piece, the power device, the insulation ceramic piece, and the heat radiator are sequentially fixed in a transverse direction with regard to the plane of the sheet structure, a heating surface of the power device is adhesively fixed to one surface of the insulation ceramic piece through a first insulating thermal conductive adhesive, the other surface of the insulation ceramic piece is adhesively fixed to a contact heat radiation surface of the heat radiator through a second insulating thermal conductive adhesive, a heat radiator pin is disposed on the heat radiator, and the heat radiator pin is mechanically connected to the circuit board, wherein the second insulating thermal conductive adhesive is an organic insulating thermal conductive adhesive with a thermal conductivity coefficient greater than 0.3 w/mk and with a modulus of elasticity of less than 5 GPa after being cured at a temperature of 25°C.

In the insulation and heat radiation structure of the power device provided by the embodiments of the present invention, the heating surface of the power device is adhesively fixed to one surface of the insulation ceramic piece through the first insulating thermal conductive adhesive and the other surface of the insulation ceramic piece is adhesively fixed to the contact heat radiation surface of the heat radiator through the second insulating thermal conductive adhesive, thereby meeting heat radiation and insulation requirements of the power device. In addition, a space occupied by the insulation and heat radiation structure of the power device can be decreased through the adhesive fixing of the insulating thermal conductive adhesive, thereby significantly improving the power density of the power supply apparatus.

### BRIEF DESCRIPTION OF THE DRAWINGS

To describe the technical solutions in the embodiments of the present invention more clearly, the following briefly describes the accompanying drawings required for describing the embodiments of the present invention.
FIG. 1 is a schematic view of an insulation and heat radiation structure of a power device provided by an embodiment of the present invention;
FIG. 2 is a schematic view of installation of the insulation and heat radiation structure of a power device shown in FIG. 1 and a circuit board.
FIG. 3 is a schematic view of arrangement of two adjacent insulation ceramic pieces; and
FIG. 4 is a schematic view of a combined insulation ceramic piece.

### DETAILED DESCRIPTION OF THE EMBODIMENTS

The following clearly describes the technical solutions in the embodiments of the present invention with reference to the accompanying drawings in the embodiments of the present invention. Apparently, the described embodiments are merely a part rather than all of the embodiments of the present invention. All other embodiments obtained by persons of ordinary skill in the art based on the embodiment of the present invention without creative efforts shall fall within the protection scope of the present invention.

Embodiments of the present invention provide an insulation and heat radiation structure of a power device, a circuit board, and a power supply apparatus, where the insulation and heat radiation structure occupies a small space, thereby significantly improving a power density of the power supply apparatus. The details are described respectively in the following.

### Embodiment 1

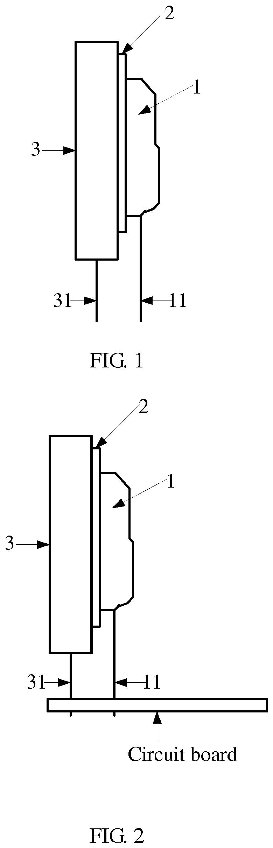

Referring to FIG. 1, FIG. 1 is a schematic view of an insulation and heat radiation structure of a power device according to Embodiment 1 of the present invention. As shown in FIG. 1, the insulation and heat radiation structure of the power device may include:
a power device 1, an insulation ceramic piece 2, and a heat radiator 3, where
the power device 1 is of a sheet structure, the insulation ceramic piece 2 is an alumina ceramic piece, and the heat radiator 3; and
the power device 1, the insulation ceramic piece 2, and the heat radiator 3 are sequentially fixed in a transverse direction, a heating surface of the power device 1 is adhesively fixed to one surface of the insulation ceramic piece 2 through a first insulating thermal conductive adhesive, and the other surface of the insulation ceramic piece 2 is adhesively fixed to a contact heat radiation surface of the heat radiator 3 through a second insulating thermal conductive adhesive.

The insulation and heat radiation structure of the power device shown in FIG. 1 may be applied to various power supply apparatuses and other modules with a power management function, such as a transformer module. A switching power supply is taken as an example. Multiple types of power devices with different package types, such as a power switch tube and a rectifier bridge, need to be used in a circuit board of the switching power supply. The power devices may have pins, and the typical package types are TO220, TO247, TO264, and the like. Generally, the heat of an internal chip of the power device is radiated to the outside through a chip bottom. That is, the heating surface of the foregoing power device 1 may be a chip bottom of an internal chip of the power device 1 (the heat is radiated to the outside through the chip bottom).

In the insulation and heat radiation structure of the power device shown in FIG. 1, a power device pin 11 may be disposed on the power device 1, and the power device pin 11 is used for being electrically connected to the circuit board, so as to achieve electrical interconnection between the power device 1 and the circuit board.

In the insulation and heat radiation structure of the power device shown in FIG. 1, a heat radiator pin 31 may be disposed on the heat radiator 3, and the heat radiator pin 31 is used for being mechanically connected to the circuit board, so as to achieve mechanical connection between the heat radiator 3 and the circuit board. In an embodiment, multiple heat radiator pins 31 may be disposed on the heat radiator 3, corresponding welding via holes may be disposed on the circuit board, and the heat radiator 3 to which the power device 1 is adhesively fixed is inserted on the circuit board, so that the power device pin 11 and the heat radiator pin 31 can be welded on the circuit board at the same time, as shown in FIG. 2.

The circuit board shown in FIG. 2 may be disposed inside various power supply apparatuses, thereby significantly improving the power density of the power supply apparatus.

When the circuit board shown in FIG. 2 is disposed inside various power supply apparatuses, a power supply output pin of a power supply board inside the various power supply apparatuses may be electrically connected to a power supply input pin of the circuit board, so as to supply power to the circuit board.

In the insulation and heat radiation structure of the power device provided by the embodiment of the present invention, the number of the insulation ceramic pieces 2 is at least 2, and a distance between two adjacent insulation ceramic pieces is greater than 3 mm, where 3 mm is a safe creepage distance. At least one power device 1 is adhesively fixed to one surface of each insulation ceramic piece 2. That is, multiple power devices 1 may be adhesively fixed to one insulation ceramic piece 2 at the same time, and multiple insulation ceramic pieces 2 may be adhesively fixed to one heat radiator 1 at the same time.

As an optional implementation mode, the insulation ceramic piece 2 may be an alumina ceramic piece with a thermal conductivity coefficient greater than 20 w/mk. According to application requirements, a thickness of the alumina ceramic piece (that is, the insulation ceramic piece 2) usually ranges from 0.5 mm to 2 mm.

As an optional implementation mode, the heat radiator 3 may be a metal heat radiator (for example, a heat radiator made of a material such as aluminum or copper). In an embodiment, the heat radiator 3 may also be a micro-pore ceramic heat radiation piece. Because of a micro-pore structure, pores in a surface area of the micro-pore ceramic heat radiation piece are 30% more than that of a metal heat radiator. Therefore, the micro-pore ceramic heat radiation piece has a larger area of contact with convective medium air and is capable of taking more heat away in the same unit time.

As an optional implementation mode, the first insulating thermal conductive adhesive may also be an organic insulating thermal conductive adhesive with a thermal conductivity coefficient greater than 0.3 w/mk. The organic insulating thermal conductive adhesive is usually formed by adding a certain quantity of insulating thermal conductive fillers (such as alumina, silicon dioxide, aluminum nitride, boron nitride, and zinc oxide) in organic resin (such as epoxy, silicone, and polyacrylic acid).

In particular, for the second insulating thermal conductive adhesive used for adhesively fixing the insulation ceramic piece 2 (such as the alumina ceramic piece) and the heat radiator 3, because of a great difference between coefficients of thermal expansion (Coefficients Of Thermal Expansion, CTE) of the insulation ceramic piece 2 (such as the alumina ceramic piece) and the heat radiator 3 (such as an aluminum radiator or a copper radiator), the second insulating thermal conductive adhesive should be an organic insulating thermal conductive adhesive with an as-small-as-possible thermal conductive adhesive modulus. Experiments show that, the best adhesive fixing effect can be achieved when the second insulating thermal conductive adhesive is an organic insulating thermal conductive adhesive with a thermal conductivity coefficient greater than 0.3 w/mk and a thermal conductive adhesive modulus less than 5 GPa after cured at a temperature of 25°C.

As an optional implementation mode, the first insulating thermal conductive adhesive may also be an organic insulating thermal conductive adhesive with a thermal conductivity coefficient greater than 0.3 w/mk and a thermal conductive adhesive modulus less than 5 GPa after cured at a temperature of 25°C.

In the embodiment of the present invention, insulating thermal conductive adhesives are coated on surfaces of the heat radiator 3 and the insulation ceramic piece 2. With an assistant tool, the power device 1, the insulation ceramic piece 2 coated with the insulating thermal conductive adhesive, and the heat radiator 3 coated with the insulating thermal conductive adhesive are mounted sequentially, and the insulating thermal conductive adhesives are cured in a specified high temperature baking condition, thereby implementing the adhesive fixing of the heat radiator 3, the insulation ceramic piece 2, and the power device 1.

In Embodiment 1 of the present invention, the heating surface of the power device 1 is adhesively fixed to one surface of the insulation ceramic piece 2 through the first insulating thermal conductive adhesive and the other surface of the insulation ceramic piece 2 is adhesively fixed to the contact heat radiation surface of the heat radiator 3 through the second insulating thermal conductive adhesive, thereby meeting heat radiation and insulation requirements of the power device 1. In addition, a space occupied by the insulation and heat radiation structure of the power device 1 can be decreased through the adhesive fixing of the insulating thermal conductive adhesive, thereby significantly improving the power density of the power supply apparatus.

### Alternative Example 1

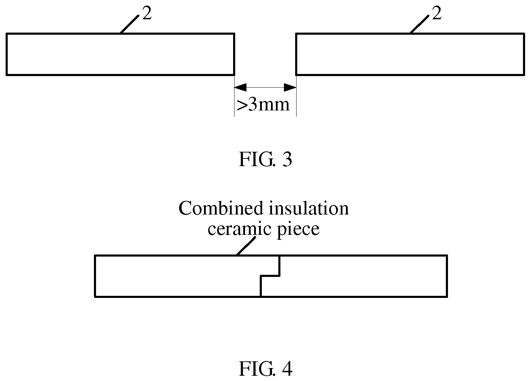

In an alternative example to the present invention, it is assumed that four TO247 power switch tubes are adhesively fixed by using two insulation ceramic pieces 2. Compared with the adhesive fixing of four TO247 power switch tubes by using one insulation ceramic piece 2, the adhesive fixing by using two insulation ceramic pieces 2 needs to add a certain distance between the two insulation ceramic pieces 2 to meet a requirement of a safe creepage distance, as shown in FIG. 3.

In the example of the present invention, to decrease a space occupied by an insulation and heat radiation structure of a power device to a greater extent, the larger the number of the power devices adhered to the same insulation ceramic piece is, the more significant the effect of saving the occupied space is. The larger the number of the power devices sharing the insulation ceramic piece is, the larger a size of the insulation ceramic piece is. The larger the size of the insulation ceramic piece is, the larger the thermal stress generated due to a temperature change is. Therefore, it is possible that the insulation ceramic piece is cracked due to the stress or the ceramic piece comes off the heat radiator, so that a power supply product is useless. The example of the present invention provides a solution of a combined insulation ceramic piece. The combined insulation ceramic piece does not increase the occupied space significantly and meanwhile does not decrease the adhesion reliability of the insulation ceramic piece. That eight TO247 power switch tubes share one insulation ceramic piece is taken as an example. If the size of the insulation ceramic piece is excessively large, and a risk of the adhesion reliability of the insulation ceramic piece is great. In the example of the present invention, the combined insulation ceramic piece shown in FIG. 4 may be used to replace a single insulation ceramic piece. Compared with the whole single insulation ceramic piece, the combined insulation ceramic piece shown in FIG. 4 has only half of the thermal stress of the whole single insulation ceramic piece and does not increase the occupied space.

### Alternative Example 2

In a further alternative example to the present invention, the first insulating thermal conductive adhesive and the second insulating thermal conductive adhesive may be organic insulating thermal conductive films, so as to avoid manual coating of insulating thermal conductive adhesives, thereby improving production efficiency. A middle part of an organic insulating thermal conductive film may be a glass fiber cloth substrate, or a PI insulating and pressure-resistant film, or a PEN insulating and pressure-resistant film, and two surfaces are disposed with a pre-cured thermal conductive adhesive. The organic insulating thermal conductive film may not have a substrate, and may be a thermal conductive adhesive film coated into a sheet shape. The organic insulating thermal conductive film may be cured for the second time after being heated at a high temperature, so as to implement the adhesive fixing of the power device 1, the insulation ceramic piece 2, and the heat radiator 3.

Compared with the existing insulation and heat radiation structure of the power device, the embodiment of the present invention can decrease the space occupied by the single insulation and heat radiation structure of the power device by approximately 50%, thereby significantly improving a power density of the whole power supply product.

## Claims

1. An insulation and heat radiation structure of a power device, comprising:
a power device (1), an insulation ceramic piece (2), and a heat radiator (3), wherein
the power device (1) is of a sheet structure, the insulation ceramic piece (2) is an alumina ceramic piece, a heat radiator pin (31) is disposed on the heat radiator (3), and the heat radiator pin (31) is used for being mechanically connected to a circuit board, wherein a power device pin (11) is disposed on the power device (1), and the power device pin (11) is used for being electrically connected to the circuit board; and
the power device (1), the insulation ceramic piece (2), and the heat radiator (3) are sequentially fixed in a transverse direction with regard to the plane of the sheet structure, a heating surface of the power device (1) is adhesively fixed to one surface of the insulation ceramic piece (2) through a first insulating thermal conductive adhesive, and the other surface of the insulation ceramic piece (2) is adhesively fixed to a contact heat radiation surface of the heat radiator (3) through a second insulating thermal conductive adhesive,
wherein the second insulating thermal conductive adhesive is an organic insulating thermal conductive adhesive with a thermal conductivity coefficient greater than 0.3 w/mk and with a modulus of elasticity of less than 5 GPa after being cured at a temperature of 25°C.

2. The insulation and heat radiation structure according to claim 1, wherein the insulation ceramic piece (2) has a thermal conductivity coefficient greater than 20 w/mk and a thickness of 0.5 mm to 2 mm.

3. The insulation and heat radiation structure according to claim 1, wherein the heat radiator (3) is a metal heat radiator.

4. The insulation and heat radiation structure according to claim 1, wherein the first insulating thermal conductive adhesive is an organic insulating thermal conductive adhesive with a thermal conductivity coefficient greater than 0.3 w/mk and with a modulus of elasticity of less than 5 GPa after being cured at a temperature of 25°C.

5. The insulation and heat radiation structure according to claim 1, wherein the first insulating thermal conductive adhesive is an organic insulating thermal conductive film, and the organic insulating thermal conductive film is a thermal conductive adhesive processed into a sheet shape in a coating manner.

6. The insulation and heat radiation structure according to claim 1, wherein the second insulating thermal conductive adhesive is an organic insulating thermal conductive film, and the organic insulating thermal conductive film is a thermal conductive adhesive processed into a sheet shape in a coating manner.

7. A circuit board, comprising an insulation and heat radiation structure of a power device formed by a power device (1), an insulation ceramic piece (2), and a heat radiator (3), wherein the power device (1) is of a sheet structure, the insulation ceramic piece (2) is an alumina ceramic piece, the power device (1), the insulation ceramic piece (2), and the heat radiator (3) are sequentially fixed in a transverse direction with regard to the plane of the sheet structure, a heating surface of the power device (1) is adhesively fixed to one surface of the insulation ceramic piece (2) through a first insulating thermal conductive adhesive, the other surface of the insulation ceramic piece (2) is adhesively fixed to a contact heat radiation surface of the heat radiator (3) through a second insulating thermal conductive adhesive, a heat radiator pin (31) is disposed on the heat radiator (3), and the heat radiator pin (31) is mechanically connected to the circuit board, wherein a power device pin (11) is disposed on the power device (1), and the power device pin (11) is used for being electrically connected to the circuit board, wherein the second insulating thermal conductive adhesive is an organic insulating thermal conductive adhesive with a thermal conductivity coefficient greater than 0.3 w/mk and with a modulus of elasticity of less than 5 GPa after being cured at a temperature of 25°C.

8. The circuit board according to claim 7, wherein the insulation ceramic piece (2) has a thermal conductivity coefficient greater than 20 w/mk and a thickness of 0.5 mm to 2 mm.

9. The circuit board according to claim 7, wherein the heat radiator (3) is a metal heat radiator.

10. The circuit board according to claim 7, wherein the first insulating thermal conductive adhesive is an organic insulating thermal conductive adhesive with a thermal conductivity coefficient greater than 0.3 w/mk and with a modulus of elasticity of less than 5 GPa after being cured at a temperature of 25°C.

## Patentansprüche

1. Isolier- und Wärmestrahlungsstruktur einer Stromversorgungsvorrichtung, umfassend:
eine Stromversorgungsvorrichtung (1), ein Isolierkeramikstück (2) und einen Wärmestrahler (3), wobei
die Stromversorgungsvorrichtung (1) eine Lagenstruktur hat, das Isolierkeramikstück (2) ein Aluminiumoxidkeramikstück ist, ein Wärmestrahlerstift (31) auf dem Wärmestrahler (3) angeordnet ist, und der Wärmestrahlerstift (31) verwendet wird, um mechanisch mit einer Schaltplatine verbunden zu werden, wobei ein Stromversorgungsstift (11) auf der Stromversorgungsvorrichtung (1) angeordnet ist und der Stromversorgungsvorrichtungstift (11) verwendet wird, um elektrisch mit der Schaltplatine verbunden zu werden; und
die Stromversorgungsvorrichtung (1), das Isolierkeramikstück (2) und der Wärmestrahler (3) nacheinander in einer Querrichtung in Bezug auf die Ebene der Lagenstruktur fixiert werden, eine Heizfläche der Stromversorgungsvorrichtung (1) klebend mittels eines ersten isolierenden wärmeleitenden Klebers an einer Oberfläche des Isolierkeramikstücks (2) fixiert ist, und die andere Oberfläche des Isolierkeramikstücks (2) klebend mittels eines zweiten isolierenden wärmeleitenden Klebers an einer Kontaktwärmestrahlungsoberfläche des Wärmestrahlers (3) fixiert ist,
wobei der zweite isolierende wärmeleitende Kleber ein organischer isolierender wärmeleitender Kleber mit einem Wärmeleitfähigkeitskoeffizienten größer als 0,3 w/mk und mit einem Elastizitätsmodul von weniger als 5 GPa ist, nachdem er bei einer Temperatur von 25 °C gehärtet wurde.

2. Isolier- und Wärmestrahlungsstruktur nach Anspruch 1, wobei das Isolierkeramikstück (2) einen Wärmeleitfähigkeitskoeffizienten größer als 20 w/mk und eine Dicke von 0,5 mm bis 2 mm hat.

3. Isolier- und Wärmestrahlungsstruktur nach Anspruch 1, wobei der Wärmestrahler (3) ein Metallwärmestrahler ist.

4. Isolier- und Wärmestrahlungsstruktur nach Anspruch 1, wobei der erste isolierende wärmeleitende Kleber ein organischer isolierender wärmeleitender Kleber mit einem Wärmeleitfähigkeitskoeffizienten größer als 0,3 w/mk und mit einem Elastizitätsmodul von weniger als 5 GPa ist, nachdem er bei einer Temperatur von 25 °C gehärtet wurde.

5. Isolier- und Wärmestrahlungsstruktur nach Anspruch 1, wobei der erste isolierende wärmeleitende Kleber ein organischer isolierender wärmeleitender Film ist und der organische isolierende wärmeleitende Film ein wärmeleitender Kleber ist, der in einer Beschichtungsweise zu einer Lagenform verarbeitet wurde.

6. Isolier- und Wärmestrahlungsstruktur nach Anspruch 1, wobei der zweite isolierende wärmeleitende Kleber ein organischer isolierender wärmeleitender Film ist, und der organische isolierende wärmeleitende Film ein wärmeleitender Kleber ist, der in einer Beschichtungsweise zu einer Lagenform verarbeitet wurde.

7. Schaltplatine, umfassend eine Isolier- und Wärmestrahlungsstruktur einer Stromversorgungsvorrichtung, die durch eine Stromversorgungsvorrichtung (1), ein Isolierkeramikstück (2) und einen Wärmestrahler (3) gebildet ist, wobei die Stromversorgungsvorrichtung (1) eine Lagenstruktur aufweist, das Isolierkeramikstück (2) ein Aluminiumoxidkeramikstück ist, die Stromversorgungsvorrichtung (1), das Isolierkeramikstück (2) und der Wärmestrahler (3) nacheinander in einer Querrichtung in Bezug auf die Ebene der Lagenstruktur fixiert werden, eine Heizoberfläche der Stromversorgungsvorrichtung (1) klebend mittels eines ersten isolierenden wärmeleitenden Klebers an einer Oberfläche des Isolierkeramikstücks (2) fixiert ist, die andere Oberfläche des Isolierkeramikstücks (2) klebend mittels eines zweiten isolierenden wärmeleitenden Klebers an einer Kontaktwärmestrahlungsoberfläche des Wärmestrahlers (3) fixiert ist, ein Wärmestrahlerstift (31) auf dem Wärmestrahler (3) angeordnet ist, und der Wärmestrahlerstift (31) mechanisch mit der Schaltplatine verbunden ist, wobei ein Stromversorgungsvorrichtungsstift (11) auf der Stromversorgungsvorrichtung (1) angeordnet ist und der Stromversorgungsstift (11) verwendet wird, um elektrisch mit der Schaltplatine verbunden zu werden, wobei der zweite isolierende wärmeleitende Kleber ein organischer isolierender wärmeleitender Kleber mit einem Wärmeleitfähigkeitskoeffizienten größer als 0,3 w/mk und mit einem Elastizitätsmodul von weniger als 5 GPa ist, nachdem er bei einer Temperatur von 25 °C gehärtet wurde.

8. Schaltplatine nach Anspruch 7, wobei das Isolierkeramikstück (2) einen Wärmeleitfähigkeitskoeffizienten größer als 20 w/mk und eine Dicke von 0,5 mm bis 2 mm hat.

9. Schaltplatine nach Anspruch 7, wobei der Wärmestrahler (3) ein Metallwärmestrahler ist.

10. Schaltplatine nach Anspruch 7, wobei der erste isolierende wärmeleitende Kleber ein organischer isolierender wärmeleitender Kleber mit einem Wärmeleitfähigkeitskoeffizienten größer als 0,3 w/mk und mit einem Elastizitätsmodul von weniger als 5 GPa ist, nachdem er bei einer Temperatur von 25 °C gehärtet wurde.

## Revendications

1. Structure d'isolation et de rayonnement thermique d'un dispositif de puissance, comprenant :
un dispositif de puissance (1), une pièce céramique d'isolation (2), et un dispositif de rayonnement thermique (3), dans laquelle
le dispositif de puissance (1) a une structure en feuille, la pièce céramique d'isolation (2) est une pièce céramique en alumine, une broche de dispositif de rayonnement thermique (31) est disposée sur le dispositif de rayonnement thermique (3), et la broche de dispositif de rayonnement thermique (31) est utilisée pour être reliée mécaniquement à une carte de circuit, dans laquelle une broche de dispositif de puissance (11) est disposée sur le dispositif de puissance (1), et la broche de dispositif de puissance (11) est utilisée pour être reliée électriquement à la carte de circuit ; et
le dispositif de puissance (1), la pièce céramique d'isolation (2) et le dispositif de rayonnement thermique (3) sont successivement fixés dans une direction transversale par rapport au plan de la structure en feuille, une surface chauffante du dispositif de puissance (1) est collée à une surface de la pièce céramique d'isolation (2) par un premier adhésif isolant thermoconducteur, et l'autre surface de la pièce céramique d'isolation (2) est collée à une surface de rayonnement thermique de contact du dispositif de rayonnement thermique (3) par un deuxième adhésif isolant thermoconducteur,
dans laquelle le deuxième adhésif isolant thermoconducteur est un adhésif isolant thermoconducteur organique avec un coefficient de conductivité thermique supérieur à 0,3 W/mK et avec un module d'élasticité de moins de 5 GPa après avoir été durci à une température de 25 °C.

2. Structure d'isolation et de rayonnement thermique selon la revendication 1, dans laquelle la pièce céramique d'isolation (2) a un coefficient de conductivité thermique supérieur à 20 W/mK et une épaisseur de 0,5 mm à 2 mm.

3. Structure d'isolation et de rayonnement thermique selon la revendication 1, dans laquelle le dispositif de rayonnement thermique (3) est un dispositif de rayonnement thermique métallique.

4. Structure d'isolation et de rayonnement thermique selon la revendication 1, dans laquelle le premier additif isolant thermoconducteur est un adhésif isolant thermoconducteur organique avec un coefficient de conductivité thermique supérieur à 0,3 W/mK et avec un module d'élasticité de moins de 5 GPa après avoir été durci à une température de 25 °C.

5. Structure d'isolation et de rayonnement thermique selon la revendication 1, dans laquelle le premier additif isolant thermoconducteur est un film isolant thermoconducteur organique, et le film isolant thermoconducteur organique est un adhésif thermoconducteur préparé en forme de feuille à la manière d'un revêtement.

6. Structure d'isolation et de rayonnement thermique selon la revendication 1, dans laquelle le deuxième adhésif isolant thermoconducteur est un film isolant thermoconducteur organique, et le film isolant thermoconducteur organique est un adhésif thermoconducteur préparé en forme de feuille à la manière d'un revêtement.

7. Carte de circuit, comprenant une structure d'isolation et de rayonnement thermique d'un dispositif de puissance constituée d'un dispositif de puissance (1), d'une pièce céramique d'isolation (2), et d'un dispositif de rayonnement thermique (3), dans laquelle le dispositif de puissance (1) a une structure en feuille, la pièce céramique d'isolation (2) est une pièce céramique en alumine, le dispositif de puissance (1), la pièce céramique d'isolation (2) et le dispositif de rayonnement thermique (3) sont successivement fixés dans une direction transversale par rapport au plan de la structure en feuille, une surface chauffante du dispositif de puissance (1) est collée à une surface de la pièce céramique d'isolation (2) par un premier adhésif isolant thermoconducteur, l'autre surface de la pièce céramique d'isolation (2) est collée à une surface de rayonnement thermique de contact du dispositif de rayonnement thermique (3) par un deuxième adhésif isolant thermoconducteur, une broche de dispositif de rayonnement thermique (31) est disposée sur le dispositif de rayonnement thermique (3), et la broche de dispositif de rayonnement thermique (31) est reliée mécaniquement à la carte de circuit, dans laquelle une broche de dispositif de puissance (11) est disposée sur le dispositif de puissance (1), et la broche de dispositif de puissance (11) est utilisée pour être reliée électriquement à la carte de circuit, dans laquelle le deuxième adhésif isolant thermoconducteur est un adhésif isolant thermoconducteur organique avec un coefficient de conductivité thermique supérieur à 0,3 W/mK et avec un module d'élasticité de moins de 5 GPa après avoir été durci à une température de 25 °C.

8. Carte de circuit selon la revendication 7, dans laquelle la pièce céramique d'isolation (2) a un coefficient de conductivité thermique supérieur à 20 W/mK et une épaisseur de 0,5 mm à 2 mm.

9. Carte de circuit selon la revendication 7, dans laquelle le dispositif de rayonnement thermique (3) est un dispositif de rayonnement thermique métallique.

10. Carte de circuit selon la revendication 7, dans laquelle le premier additif isolant thermoconducteur est un adhésif isolant thermoconducteur organique avec un coefficient de conductivité thermique supérieur à 0,3 W/mK et avec un module d'élasticité de moins de 5 GPa après avoir été durci à une température de 25 °C.
